Europäisches Patentamt

European Patent Office

Office européen des brevets

(19)

(11) Publication number: **0 202 291**
**B1**

# EUROPEAN PATENT SPECIFICATION

(12)

(45) Date of publication of the patent specification:
01.03.89

(51) Int. Cl.⁴: **H 05 K 3/28**

(21) Application number: **85905863.8**

(22) Date of filing: **25.11.85**

(86) International application number:
**PCT/GB 85/00541**

(87) International publication number:
**WO 86/03366 (05.06.86 Gazette 86/12)**

(54) IMPROVEMENTS RELATING TO PROTECTIVELY COATING ELECTRICAL EQUIPMENT.

(30) Priority: **24.11.84 GB 8429754**

(43) Date of publication of application:
**26.11.86 Bulletin 86/48**

(45) Publication of the grant of the patent:
**01.03.89 Bulletin 89/9**

(84) Designated Contracting States:
**AT BE CH DE FR GB IT LI LU NL SE**

(56) References cited:
**GB-A- 1 403 776**

**IBM Technical Disclosure Bulletin, volume 7, no. 11, 11 April 1965, New York (US). W.M. Howard et al.: "Pressure-Vacuum Coating Device", pages 985, 986**
**Patents Abstracts of Japan, volume 8, no. 264, (E-282)(1701) 4 December 1984 & JP A 59134861 (HITACHI SEISAKUSHO K.K.) 2 August 1984**

(73) Proprietor: **PLESSEY OVERSEAS LIMITED, Vicarage Lane, Ilford Essex IGI 4AQ (GB)**

(72) Inventor: **WALLACE, Christopher, 21 Lysander Close Christchurch, Dorset (GB)**
Inventor: **SIBLEY, Mark, 75 Meadowsweet Road Centurions Way, Creekmoor, Poole Dorset (GB)**

## Description

This invention relates to methods of applying protective coatings to electrical equipment for the protection of such equipment against adverse environmental conditions. More specifically the invention is directed to the coating of so-called multi-layer back plane panels and other electronic panels having a multiplicity of rows of electrical connectors or other electrical components mounted thereon.

According to one known method of applying such protective coatings to back plane panels on which are mounted rows of printed circuit board edge connectors the panel is dipped into a bath of coating material (e.g. HUMISEAL 1B31) after masking certain regions of the panel or components mounted thereon as required. The dipping operation ensures that the panel surface including those areas between the edge connectors are adequately coated but that the depth of dipping does not cause the coating material to enter the board receiving ends of the connectors. However, it has been found that due to capillary action coating material has penetrated and risen up into certain interstices of the edge connector bodies from the panel surface end of the connectors and thereby caused electrical contact problems in such connectors.

According to the present invention the aforesaid problems due to capillary action occurring during dipping operations are avoided by protectively coating the regions of the panel between rows of electrical connectors or the like by means of a process in which protective coating material of accurately controlled consistency and volume is fed under pressure through a nozzle accurately located in predetermined spaced relationship with the panel surface and between rows of said connectors or other components whilst the panel and nozzle are moved at a predetermined speed and in predetermined positional relationship relative to one another.

The accurate control of the consistency and volume of the protective material dispensed by the nozzle together with the positioning of the nozzle and the relative speed of movement between the nozzle and the panel being coated ensure that just the right amount of protective material is applied to the panel surface between the connectors or the like to allow the material to spread out and provide an adequate protective coating on the panel surface without any surplus being available to rise up through the connector bodies by capillary action as previously described.

The present invention lends itself admirably to computer-controlled robotic application of the protective coating material through a syringe injection nozzle carried by a movable robot arm which will be controlled so that it moves in accordance with a suitable computer program relative to one or more stationary electronic panels to be coated so that the syringe nozzle moves to an fro along the channels defined between respective rows of edge connectors.

By reason of accurate control which can be exercised during the coating operation the present invention ensures high quality of the protective coatings as well as good efficiency and repeatability of the coating operation under computer controlled conditions. Computer control of the process also affords good flexibility and process capability by appropriate choice of computer programs.

Other areas of the panel and/or components moulded thereon, either before of after application of protective coating material by the injection process of the present invention, may be coated by spraying coating material on to these areas and/or components through a suitable spray gun.

By way of example the present invention will now be described with reference to the accompanying drawing in which:

Figure 1 shows a perspective diagrammatic view of a computer-controlled robot machine for applying protective coating material to multi-layer back plane panels; and,

Figure 2 is a fragmentary diagrammatic view showing an injection nozzle carried by the robot machine arm and located between adjacent rows of electrical connectors.

Referring to the drawing, the robot machine 1 includes a movable arm 2 and is located in predetermined positional relationship with a work support table 3 which can be rotated through 180° in the horizontal plane, as required, for the selective positioning of multi-layer back plane panels 4 and 5 supported by the work table 3 relative to the robot arm 2.

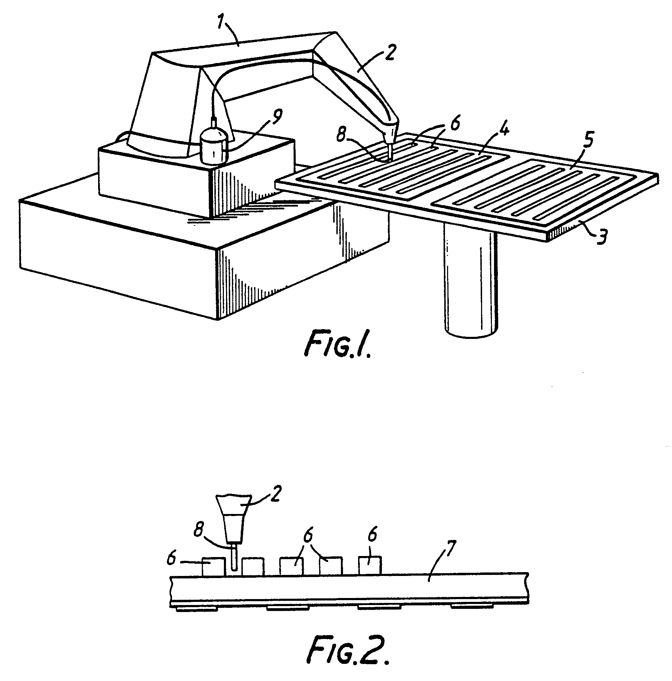

As can be seen from Figure 2, each of the back plane panels comprises rows of electrical connectors 5 between which protective coating material is required to be applied to the surface 7 of the panel. In order to apply such material so that the requisite protection is afforded without the risk of surplus coating material rising up through interstices of the electrical connector bodies due to capillary action as has been the case when dipping procedures have been adopted for providing the protective coating, the present invention makes use of robot machine 1 which is controlled by means of a computer suitably programmed so that the robot arm 2 which carries an injection nozzle 8 moves along a path to and fro across the panel whereby the injection nozzle 8 moves along each channel in turn between adjacent rows of electrical connectors. Coating material (e.g. HUMISEAL 1B31) of accurately predetermined viscosity will be fed to the nozzle 8 from a reservoir 9 where te material is pressurised by means of a suitable inert gas (e.g. NITROGEN OR ARGON). The consistency of the coating material and the rate at which the material is dispensed by the nozzle 8 and the speed of movement of the nozzle along the channels between the connectors as well as the distance of the nozzle from the panel surface will all be accurately controlled in order to ensure high quality protective coatings.

After one of the panels (4) has been coated between connectors by the robot machine in accordance with the invention the work table 3 may be rotated automatically through 180° in order to present the other back plane panel (5) to the robot arm in readiness for coating. After coating the second panel both panels 4 and 5 may be removed from the work table 3 and two further panels inserted in the support table in readiness for coating.

As previously mentioned other local areas of the back plane panels may be coated by spraying etc. as required before or after the panels are coated between the electrical connectors by means of the robot machine.

**Claims**

1.   A method of applying a protective coating to an electronical panel having a multiplicity of rows of electrical connectors or other electrical components mounted thereon, chacterised in that the regions of the panel between the rows of electrical connectors or other electrical components are protectively coated by means of a process in which protective coating material of accurately controlled consistency and volume is fed under pressure through a nozzle accurately located in predetermined spaced relationship with the panel surface and between rows of said connectors or other components whilst the panel and nozzle are moved at a predetermined speed and in predetermined positional relationship relative to one another.

2.   A method as claimed in claim 1, characterised in that a computer-controlled robot controls the application of the protective coating material through a syringe injection nozzle carried by a movable robot and controlled so that it moves in accordance with a a computer program relative to one or more stationary electronic panels to be coated so that the syringe nozzle moves to and fro along the channels defined between respective rows of electrical components.

3.   A method as claimed in claim 1, characterised in that selected parts and/or components mounted on the board are coated with suitable coating material by spraying before or after the application of the coating material to the panel between the rows of electrical components.

**Patentansprüche**

1.   Verfahren für das Aufbringen eines Schutzüberzuges auf ein elektronisches Feld, das eine Vielzahl Reihen elektrischer Anschlüsse oder anderer darauf angeordneter elektrischer Komponenten umfasst, dadurch gekennzeichnet, dass die Bereiche des Feldes zwischen den Reihen der elektrischen Anschlüsse oder anderer elektrischer Komponenten mittels eines Prozesses schützend beschichtet werden, gemäss welchem schützendes Beschichtungsmaterial von genau beherrschter Zusammensetzung und Volumen unter Druck durch eine Düse zugeführt wird, die genau in vorgegebener räumlicher Beziehung mit der Feldoberfläche und zwischen Reihen der besagten Anschlüsse oder anderer Komponenten positioniert wird, während das Feld und die Düse mit vorgegebener Geschwindigkeit und in vorgegebener Positionsbeziehung relativ zueinander bewegt werden.

2.   Verfahren nach Anspruch 1, dadurch gekennzeichnet, dass ein computergesteuerter Roboter das Auftragen des schützenden Beschichtungsmaterials durch eine Spritzinjektionsdüse steuert, die auf einem bewegbaren Roboter angeordnet ist und so gesteuert wird, dass sie gemäss einem Computer-Programm relativ zu einem oder mehreren stationären elektronischen Feldern bewegt wird, die zu beschichten sind, so dass die Spritzdüse hin und her entlang den Kanälen bewegt wird, die zwischen entsprechenden Reihen elektrischer Komponenten ausgebildet sind.

3.   Verfahren nach Anspruch 1, dadurch gekennzeichnet, dass ausgewählte Teile und/oder Komponenten, die auf dem Feld angeordnet sind, mit geeignetem Material, vor oder nach dem Aufbringen des Beschichtungsmaterials auf das Feld zwischen den Reihen elektrischer Komponenten, durch Aufsprühen beschichtet werden.

**Revendications**

1.   Procédé d'application d'un revêtement protecteur à un panneau électronique ayant plusieurs lignes de connecteurs électriques ou d'autres composants électriques montés sur lui, caractérisé en ce que les régions du panneau comprises entre les lignes de connecteurs électriques ou d'autres composants électriques sont munis d'un revêtement protecteur réalisé au cours d'un procédé dans lequel une matière protectrice de revêtement de volume et de consistance réglés avec précision est transmise sous pression par une buse positionnée avec précision en position relative prédéterminée par rapport à la surface du panneau et entre les lignes des connecteurs ou d'autres composants pendant que le panneau et la buse sont déplacés à une vitesse prédéterminée et en position relative prédéterminée l'un par rapport à l'autre.

2.   Procédé selon la revendication 1, caractérisé en ce qu'un robot commandé par ordinateur règle l'application de la matière protectrice de revêtement par l'intermédiaire d'une buse d'injection à seringue portée par un robot mobile et commandé de manière qu'il se déplace en fonction d'un programme d'ordinateur par rapport à un ou plusieurs panneaux électroniques fixes destinés à être revêtus, si bien que la buse à seringue se déplace en translation le long des canaux délimités entre les lignes respectives de composants électriques.

3.   Procédé selon la revendication 1, caractérisé en ce que des parties choisies et/ou des composants choisis montés sur la carte sont revêtus d'une matière convenable de revêtement par pulvérisation, avant ou après l'application de la matière de revêtement aux panneaux entre les lignes de composants électriques.

FIG.1.

FIG.2.

5